# FASCICULE DE BREVET EUROPEEN

(11) **EP 3 470 853 B1**
(45) Date de publication et mention de la délivrance du brevet: **02.10.2024**
(21) Numéro de dépôt: 18188554.2
(22) Date de dépôt: 10.08.2018
(51) Int. Cl.: G01R 15/14

(54) **DISPOSITIF DE MESURE DE COURANT, PROCEDE DE FABRICATION, MODULE DE PROTECTION ET DISJONCTEUR DIFFERENTIEL UTILISANT UN TEL DISPOSITIF DE MESURE DE COURANT**
STROMMESSVORRICHTUNG, HERSTELLUNGSVERFAHREN, SCHUTZMODUL UND FEHLERSTROMSCHUTZSCHALTER, DER EINE SOLCHE STROMMESSVORRICHTUNG NUTZT
CURRENT MEASURING DEVICE, METHOD OF MANUFACTURE, PROTECTION MODULE AND DIFFERENTIAL CIRCUIT BREAKER USING SUCH A CURRENT MEASURING DEVICE

(30) Priorité: 16.10.2017 FR 1759659
(43) Date de publication de la demande: 17.04.2019
(73) Titulaire: Schneider Electric Industries SAS, 92500 Rueil-Malmaison (FR)
(72) Inventeur: GRUMEL, Christophe, 38050 GRENOBLE (FR); BRASME, Frédéric, 38050 GRENOBLE (FR); LE GRAND, Nathalie, 38050 GRENOBLE (FR)
(74) Mandataire: Schneider Electric

(56) Documents cités:
- EP-A1- 0 926 695
- EP-A1- 1 475 874
- EP-A1- 1 736 784
- EP-A1- 2 466 611
- EP-A1- 2 648 010
- EP-A2- 2 355 265
- FR-A1- 2 938 129
- JP-A- H07 105 822
- JP-A- H1 098 806
- KR-B1- 101 665 952

## Description

### DOMAINE TECHNIQUE

La présente invention concerne un dispositif destiné à la mesure du courant circulant dans des lignes électriques et à la mesure d'un courant différentiel. L'invention concerne également un procédé de fabrication du dispositif de mesure du courant. L'invention concerne également un module de protection contre les défauts électriques et un disjoncteur différentiel comportant un tel dispositif de mesure du courant.

### ETAT DE LA TECHNIQUE

Des dispositifs de protection contre les courants de défaut sont utilisés très largement dans les installations électriques alimentées par des lignes d'un réseau alternatif. Leur fonction est de détecter tout courant de défaut, qu'il soit lié à une surintensité dans une des lignes ou à un défaut d'isolement créant une fuite de courant à la terre. Ces dispositifs de protection comportent une fonction de mesure des courants pour détecter tout dépassement de seuil et une fonction d'ouverture du circuit électrique pour éliminer le défaut. Généralement, quand la seule fonction de mesure du courant circulant dans les lignes est nécessaire, elle est groupée avec la fonction d'ouverture du circuit électrique dans un même appareil. En revanche, quand la détection de courant de fuite à la terre est également nécessaire, plusieurs difficultés apparaissent : la mesure du courant circulant dans les lignes nécessite un capteur par ligne alors que la mesure du courant de fuite à la terre, appelé aussi courant différentiel, nécessite un capteur pour effectuer la somme vectorielle de tous les courants circulant dans toutes les lignes de courant. Le cheminement des conducteurs de courant devient compliqué, la nécessité de garantir une isolation entre les conducteurs et le besoin d'une réalisation industrielle à un coût acceptable, accentuent les difficultés de construction.

Un premier moyen de résoudre ces problèmes est la réalisation de la fonction de mesure du courant différentiel au moyen d'un premier produit séparé et la réalisation de la fonction de mesure du courant circulant dans les lignes et la fonction d'ouverture de circuit au moyen d'un second produit. Par exemple, le document US 2011/0116197 A1 décrit un dispositif de mesure de courant différentiel implanté dans un produit séparé. Le document FR 2 772 979 B1 divulgue un bloc différentiel pouvant être raccordé sur le côté d'un disjoncteur. Cependant, une intégration, dans un seul dispositif, d'une fonction d'ouverture de circuit, des capteurs pour la mesure des courants circulant dans les lignes et d'un capteur pour la détection de courant différentiel est économiquement intéressante à cause de la réduction du nombre de boitiers et du nombre de bornes de raccordement. D'autre part, il est très intéressant de disposer d'un produit ayant un encombrement similaire à un dispositif de protection non équipé de protection différentielle : cela simplifie l'installation dans un tableau électrique, tous les équipements étant alignés, les raccordements sont plus simples, en particulier dans le cas de raccordement par des barres de cuivre rigides. Enfin, la réduction de l'encombrement permet à l'utilisateur d'installer un plus grand nombre d'appareils dans un tableau électrique.

Le document JP 2011-34714 A divulgue un disjoncteur différentiel qui intègre des capteurs de courant 6 pour mesurer les courants circulant dans les lignes et un capteur 7 pour la détection du courant différentiel. Le capteur 7 est placé dans le prolongement des capteurs de courant 6 ce qui allonge la taille du boitier et le rend différent en taille par rapport à un disjoncteur ne disposant pas de fonction différentielle. D'autre part, la forme oblongue du capteur de courant différentiel 7 rend le capteur 7 sensible au courant circulant dans les lignes 50 et la précision de mesure du courant différentiel peut être altérée quand le courant circulant dans les lignes devient important.

Le document JPH0878259 A décrit un disjoncteur différentiel triphasé utilisant seulement deux capteurs 11U et 11W pour mesurer les courants circulant dans les lignes 32U et 32W et un capteur de courant différentiel 33. Une évaluation du courant circulant dans la ligne 32 V est obtenue en effectuant la somme vectorielle des courants circulant dans les lignes 32U et 32W. Cette solution réduit évidemment l'espace occupé et simplifie la réalisation mais le calcul du courant dans la phase 32V cumule les erreurs de mesure des courants circulant dans les lignes 32U et 32W et doit prendre en compte le courant différentiel présent. Cette solution est intéressante dans le cadre d'une protection dite « protection terre » ou « ground fault protection » en langage anglo-saxon, mais n'est pas adaptée à une protection différentielle destinée à la protection des personnes pour laquelle le seuil de protection en courant différentiel est bas, par exemple 30 mA, ni à une mesure précise du courant circulant dans les phases pour obtenir une mesure de puissance ou d'énergie.

Les documents EP1736784 A1 ou KR 101665 952 B1 décrivent un agencement des capteurs de courant et d'un capteur différentiel orientés selon un même axe. Le document JP H10 98806A décrit un ensemble de capteurs dont les bornes d'entrée sont décalées par rapport aux bornes de sortie ce qui impacte la compacité de l'ensemble.

### EXPOSE DE L'INVENTION

La présente invention vise à remédier aux inconvénients présentés par les documents antérieurs. Plus particulièrement, la présente invention décrit un dispositif compact permettant une mesure du courant circulant dans chaque ligne électrique et une mesure du courant différentiel. Ce dispositif peut être intégré dans un module de protection contre les surintensités pour apporter une protection différentielle et ainsi permettre de transformer un disjoncteur conventionnel en disjoncteur différentiel, simplement par changement du module de protection, sans pénaliser l'encombrement du disjoncteur. Cet aspect est très avantageux pour l'utilisateur.

Pour cela, le dispositif de mesure de courant est agencé pour être implanté dans un boîtier de forme sensiblement parallélépipédique comportant une face amont opposée à une face aval, une face avant opposée à une face arrière et une première face latérale opposée à une deuxième face latérale, ledit dispositif de mesure de courant comportant :
- au moins deux plages de raccordement amont destinées à être raccordées électriquement à des plages de raccordement d'un dispositif de coupure de courant électrique pour la protection de, au moins deux, lignes électriques,
- au moins deux plages de raccordement aval, destinées à être raccordées électriquement à des bornes d'utilisation,
- au moins deux conducteurs de courant, chaque conducteur de courant étant agencé pour relier électriquement respectivement une plage de raccordement amont à une plage de raccordement aval,
- au moins deux capteurs de courant, chaque capteur de courant étant disposé respectivement autour d'un conducteur de courant pour former respectivement un passage du conducteur de courant suivant un axe orienté selon une première direction dans le sens face amont -face aval, et
- un capteur de courant différentiel,

ledit dispositif de mesure de courant étant tel que le capteur de courant différentiel est disposé autour de l'ensemble des, au moins deux, conducteurs de courant pour former un passage commun aux conducteurs de courant suivant un axe orienté selon une deuxième direction dans le sens face avant-face arrière,
chaque plage de raccordement amont (11, 21) est alignée suivant un axe orienté selon la première direction (X) avec respectivement chaque plage de raccordement aval (15, 25) à laquelle ladite plage de raccordement amont (11, 21) est reliée respectivement par un conducteur de courant (10, 20),
le dispositif étant destiné à la mesure des courants circulant dans trois lignes de phase et une ligne de neutre d'un réseau électrique triphasé, comportant un premier, un deuxième et un troisième capteur de courant (51, 52, 53), chaque capteur de courant étant destiné à mesurer un courant circulant dans chacune des phases, et comportant un quatrième capteur de courant (54) destiné à mesurer un courant dans la ligne de neutre, caractérisé en ce que le quatrième capteur de courant (54) est disposé autour d'un conducteur neutre (40) pour former un passage du conducteur de courant (54A) suivant un axe orienté selon une troisième direction (Z) dans un sens première face latérale (7) -deuxième face latérale (8).

Préférentiellement, les capteurs de courant d'une part et le capteur de courant différentiel d'autre part sont implantés respectivement dans des espaces superposés entre la face avant et la face arrière de telle sorte que :
- les capteurs de courant sont disposés dans un premier espace du boitier, ledit premier espace étant délimité par la face avant, la première face latérale, la deuxième face latérale, la face amont, la face aval et un plan d'interface situé entre la face avant et la face arrière, et
- le capteur de courant différentiel est disposé dans un deuxième espace du boitier, ledit deuxième espace étant délimité par le plan d'interface, la première face latérale, la deuxième face latérale, la face amont, la face aval et la face arrière.

Préférentiellement, les plages de raccordement amont sont situées au niveau du deuxième espace du boitier.

Préférentiellement, les plages de raccordement aval sont situées au niveau du premier espace du boitier.

Préférentiellement, chaque conducteur de courant est composé de trois portions :
- une première portion de conducteur connectée électriquement, à une première de ses extrémités, à la plage de raccordement amont, ladite première portion de conducteur étant agencée pour traverser le passage commun du capteur de courant différentiel et agencée pour être connectée électriquement, à une deuxième de ses extrémités, à une première extrémité d'une deuxième portion de conducteur,
- la deuxième portion de conducteur de section rectangulaire, connectée électriquement, à une première de ses extrémités, à la deuxième extrémité de la première portion de conducteur, ladite première extrémité étant disposée sensiblement dans le plan d'interface et coudée à une seconde de ses extrémités pour former une plage plate orientée dans un plan perpendiculaire à la première direction, et
- une troisième portion de conducteur, connectée électriquement, à une première de ses extrémités, à la plage plate formée par la seconde extrémité de la deuxième portion de conducteur, ladite troisième portion de conducteur étant agencée pour traverser le passage d'un capteur de courant et agencée pour être connectée électriquement, à une deuxième de ses extrémités, à la plage de raccordement aval.

Dans un mode de réalisation particulier, chaque troisième portion de conducteur traverse au moins deux fois le passage du capteur de courant qui l'entoure en formant une boucle.

De préférence, la section de la première, deuxième et troisième portion de chaque conducteur est de surface sensiblement identique.

L'invention concerne également un procédé de fabrication d'un dispositif de mesure de courant tel que décrit précédemment, ledit procédé comportant les étapes suivantes :
- la soudure de chaque première extrémité de chaque deuxième portion de conducteur à chaque seconde extrémité de chaque première portion de conducteur pour former un segment de chaque conducteur de courant,
- le dépôt d'un revêtement isolant sur chaque segment de conducteur pour assurer l'isolation électrique de chaque segment de conducteur, des premières et deuxièmes extrémités de chacun desdits segments de conducteurs étant épargnées de revêtement pour recevoir une soudure ultérieurement,
- la soudure respectivement de chaque plage de raccordement aval à chaque deuxième extrémité de chaque troisième portion,
- la traversée respectivement de chaque troisième portion de chacun des conducteurs dans le passage formé respectivement par le capteur de courant,
- la sélection d'une variante de fabrication simple traversée ou double traversée et, dans le cas d'une double traversée ;
   - une étape de cambrage des troisièmes portions des conducteurs de courant pour former une boucle autour de respectivement chaque, et
   - une deuxième traversée de chaque troisième portion de chacun des conducteurs dans le passage,
- la soudure respectivement de chaque première extrémité de chaque troisième portion à chaque segment au niveau de la deuxième extrémité des deuxièmes portions,
- la traversée des premières extrémités des segments de conducteur dans le passage commun formé par le capteur de courant différentiel,
- la soudure respectivement de chaque plage de raccordement amont à chaque première extrémité de chaque segment de conducteur, et
- le positionnement d'un croisillon pour maintenir les premières extrémités des premières portions dans une position prédéfinie.

L'invention a également pour objet un module de protection contre les défauts électriques destiné à coopérer avec un dispositif de coupure de courant électrique, ledit module de protection comportant :
- une unité de traitement,
- un actionneur pour actionner le dispositif de coupure de courant électrique, et
- un dispositif de réglage relié à l'unité de traitement, ledit dispositif de réglage étant agencé pour régler au moins un premier seuil de déclenchement et/ou un second seuil de déclenchement,
- un dispositif de mesure de courant tel que décrit précédemment et comportant :
   - au moins deux capteurs de courant,
   - un capteur de courant différentiel, et
   - au moins deux conducteurs de courant reliés électriquement à des plages amont et des plages aval,
l'unité de traitement étant connectée aux capteurs de courant et au capteur de courant différentiel pour former :
- au moins une mesure du courant circulant dans chacun des conducteurs de courant, et
- une mesure du courant différentiel sur l'ensemble des conducteurs de courant, l'unité de traitement étant agencée pour activer l'actionneur pour actionner le dispositif de coupure de courant électrique quand au moins une mesure de courant ou quand la mesure de courant est supérieure au premier seuil de déclenchement ou quand la mesure du courant différentiel est supérieure au second seuil de déclenchement.

L'invention concerne également un disjoncteur différentiel destiné à assurer une protection contre des défauts électriques d'un circuit électrique comportant au moins deux lignes électriques, ledit disjoncteur comportant :
- au moins deux bornes de raccordement amont pour connecter au moins les deux lignes électriques,
- au moins deux bornes de raccordement interne, et
- un dispositif de coupure de courant électrique,
- un module de protection contre les défauts électriques tel que décrit précédemment, et tel que :
   - le dispositif de coupure de courant électrique est connecté entre les, au moins deux, bornes de raccordement amont et les, au moins deux, bornes de raccordement interne, ledit dispositif de coupure de courant électrique comportant des contacts permettant d'établir ou d'interrompre le courant circulant entre les, au moins deux, bornes de raccordement amont et les, au moins deux, bornes de raccordement interne,
   - les, au moins deux, bornes de raccordement interne étantt connectées aux, au moins deux, plages amont du module de protection,
   - le dispositif de coupure de courant électrique du disjoncteur différentiel étant connecté et agencé pour recevoir et exécuter une commande émise par un actionneur du module de protection.

### BREVE DESCRIPTION DES DESSINS

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :
- la figure 1 représente une vue en perspective d'un dispositif de mesure de courant destiné à un réseau triphasé avec neutre distribué selon un mode de réalisation préférentiel,
- la figure 2 est une représentation schématique d'un conducteur de courant dans une phase du dispositif de mesure montrant un agencement des plages de raccordement, des différentes portions du conducteur de courant et de plusieurs capteurs,

- la figure 3 est une représentation schématique de l'agencement du dispositif de mesure destinée à un réseau triphasé avec neutre distribué, selon un mode de réalisation préférentiel,
- la figure 4 est une représentation schématique d'un conducteur de courant de neutre du dispositif de mesure montrant un agencement de plages de raccordement, de différentes portions du conducteur de courant et de plusieurs capteurs,
- la figure 5 représente une vue en perspective du dispositif de mesure de courant, vue sous le même angle que la figure 1, le dispositif ne comportant pas la représentation de capteurs de courant afin de montrer clairement l'agencement des conducteurs de courant,
- la figure 6 représente une vue en perspective du dispositif de mesure de courant afin d'illustrer un alignement entre des plages de raccordement,
- la figure 7 représente une vue détaillée, en perspective et selon un mode de réalisation préférentiel, d'un conducteur de courant dans une phase du dispositif de mesure, afin de montrer les différentes portions constituantes,
- la figure 8 représente une vue détaillée, en perspective et selon un mode de réalisation préférentiel, d'un conducteur de courant destiné à être connecté à une ligne de neutre,
- la figure 9 représente une vue en perspective d'un dispositif de mesure de courant, similaire à la figure 1, pour illustrer l'agencement de conducteurs de courant dans les capteurs dans une variante comportant une double traversée desdits capteurs, ces derniers n'étant pas représentés,
- la figure 10 représente une vue en perspective du dispositif de mesure de courant selon une variante tripolaire,
- la figure 11 représente une vue en perspective du dispositif de mesure de courant illustrant l'utilisation d'un croisillon pour le maintien des conducteurs de courant,
- la figure 12 représente un organigramme d'un procédé de fabrication d'un dispositif de mesure de courant 1,
- la figure 13 est une représentation synoptique d'un module de protection contre les défauts électriques comportant un dispositif de mesure de courant de l'invention, et
- la figure 14 est une représentation synoptique d'un disjoncteur différentiel comportant un module de protection tel que représenté en figure 13.

### DESCRIPTION DETAILLEE DE MODES DE REALISATION PREFERES

Le dispositif de mesure de courant 1 est destiné préférentiellement à la mesure de courant dans une installation électrique alimentée par un réseau triphasé comportant une ligne de neutre, mais peut être utilisé sur tout réseau électrique comportant au moins deux phases ou au moins une phase et un neutre. Le dispositif permet la mesure du courant circulant dans les lignes électriques et d'un courant différentiel.

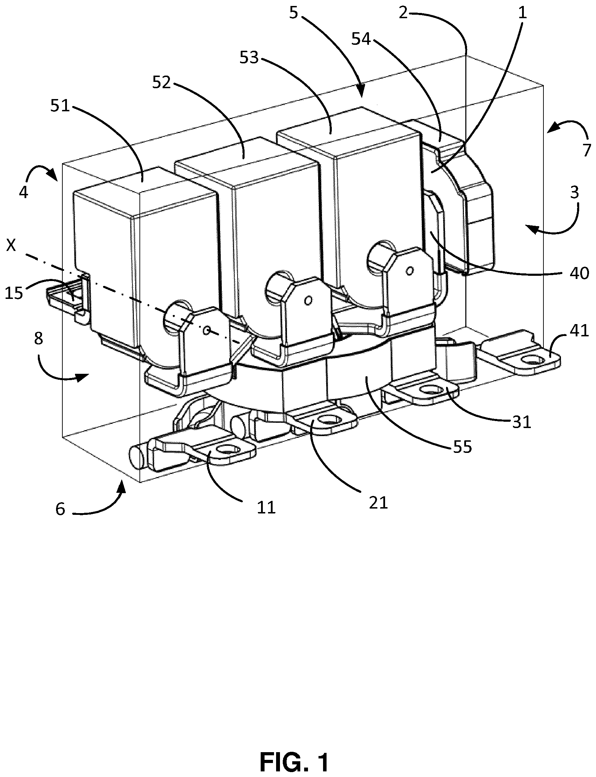

La figure 1 représente une vue en perspective du dispositif de mesure de courant 1 selon un mode de réalisation préférentiel. Le dispositif de mesure de courant 1 est agencé pour être implanté dans un boîtier 2 de forme sensiblement parallélépipédique comportant une face amont 3 opposée à une face aval 4, une face avant 5 opposée à une face arrière 6, et une première face latérale 7 opposée à une deuxième face latérale 8. La face avant 5 est orientée préférentiellement vers l'utilisateur. Le dispositif de mesure de courant 1 comporte :
- des plages de raccordement amont 11, 21, 31, 41 pour être connecté à un dispositif de coupure de courant électrique situé en amont dans un circuit électrique, ces plages étant disposées du côté de la face amont 3,
- des plages de raccordement aval 15, 25, 35, 45, pour être connecté à des bornes d'utilisation destinées à assurer une liaison électrique vers des charges électriques, ces plages étant disposées du côté de la face aval 4,
- des conducteurs de courant 10, 20, 30, 40 pour assurer une liaison électrique respectivement entre les plages de raccordement amont 11, 21, 31, 41 et les plages de raccordement aval 15, 25, 35, 45,
- des capteurs de courant 51, 52, 53 et 54, chaque capteur entourant un conducteur de courant pour mesurer le courant circulant dans ledit conducteur de courant, et
- un capteur de courant différentiel 55 entourant l'ensemble des conducteurs de courant pour mesurer le courant différentiel, c'est-à-dire le résultat de la somme vectorielle des courants circulant dans tous les conducteurs de courant. Un courant différentiel non nul correspond à une fuite de courant se rebouclant généralement par un conducteur de protection. Selon le mode de réalisation préférentiel illustré en figure 1, le dispositif de mesure de courant 1 est destiné à être connecté à un réseau triphasé avec une ligne de neutre distribuée, la ligne de neutre devant être connectée à la plage de raccordement amont 41, le raccordement du neutre côté aval pour l'utilisateur devant être réalisé sur la plage de raccordement aval 45.

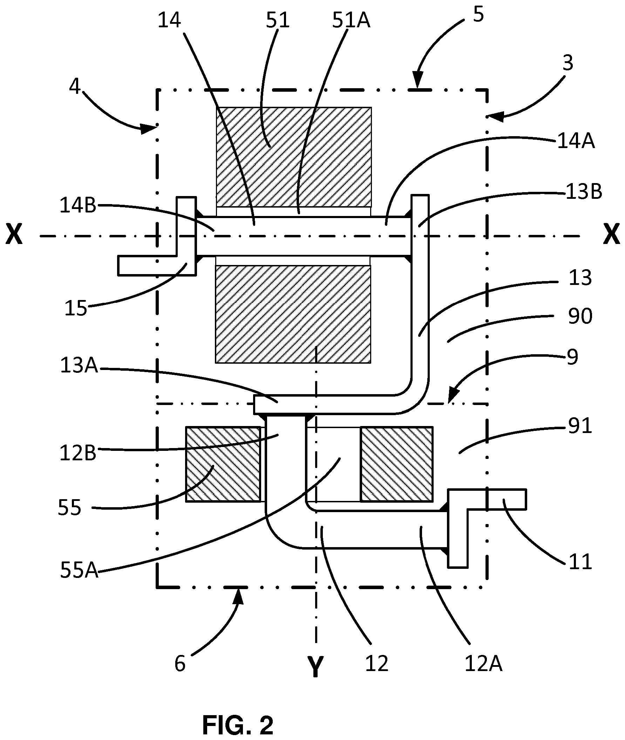

Les capteurs de courant 51, 52 et 53 sont disposés respectivement autour d'un conducteur de courant 10, 20 et 30 pour former respectivement un passage du conducteur de courant suivant un axe orienté selon une première direction X dans le sens face amont 3 - face aval 4. Pour réaliser un dispositif de mesure de courant compact, le capteur de courant différentiel 55 est disposé autour de l'ensemble des conducteurs de courant 10, 20, 30,40 pour former un passage commun 55A suivant un axe orienté selon une deuxième direction Y dans le sens face avant 5 - face arrière 6. Afin de montrer clairement la première direction X et la seconde direction Y, la figure 2 montre un agencement de la plage de raccordement amont 11, du conducteur de courant 10, du capteur de courant différentiel 55, du capteur de courant 51 et de la plage aval 15. Le conducteur de courant 10 est composé de trois portions :
- une première portion 12, connectée électriquement et mécaniquement, préférentiellement au moyen d'une soudure, à une première de ses extrémités 12A, à la plage de raccordement amont 11,
- une deuxième portion 13 connectée mécaniquement et électriquement, préférentiellement au moyen d'une soudure, à une première de ses extrémités 13A, à la seconde extrémité 12B de la première portion 12, et
- une troisième portion 14 connectée mécaniquement et électriquement, préférentiellement au moyen d'une soudure, à une première de ses extrémités 14A, à la seconde extrémité 13B de la deuxième portion 13, et, à une seconde de ses extrémités 14B, connectée mécaniquement et électriquement à la plage de raccordement aval 15.

La première portion 12 forme un coude entre ses deux extrémités 12A et 12B. Le capteur de courant différentiel 55 forme un passage 55A traversé par la seconde extrémité 12B de la première portion 12 du conducteur de courant 10. Le passage 55A est orienté suivant un axe orienté selon la deuxième direction Y, dans le sens face avant 5 - face arrière 6. La troisième portion 14 du conducteur de courant 10 traverse le passage 51A formé par le capteur de courant 51 suivant un axe orienté selon la première direction X dans le sens face amont 3 - face aval 4. L'axe orienté selon la première direction X et l'axe orienté selon la deuxième direction Y sont sensiblement orthogonaux.

Deux espaces 90 et 91 sont définis à l'intérieur du boitier 2. Un premier espace 90 est délimité par la face avant 5, la première face latérale 7, la deuxième face latérale 8, la face amont 3, la face aval 4 et un plan d'interface 9 situé entre la face avant 5 et la face arrière 6. Un deuxième espace 91 est composé par l'espace du boitier 2 ne faisant pas partie du premier espace 90. Le deuxième espace 91 est délimité par le plan d'interface 9, la première face latérale 7, la deuxième face latérale 8, la face amont 3, la face aval 4 et la face arrière 6. Le capteur de courant 51 est situé dans le premier espace 90. Le capteur de courant différentiel 55 est disposé dans le deuxième espace 91. Le plan d'interface passe par la première extrémité 13A de la deuxième portion 13 du conducteur de courant 10.

L'implantation ainsi décrite des capteurs de courant permet une implantation dans le boitier 2 en minimisant la distance entre la face avant 5 et la face arrière 6 et surtout la distance entre la face amont 3 et la face aval 4. En effet, l'orientation suivant la deuxième direction Y, sensiblement orthogonale à la première direction X, du capteur de courant différentiel 55 permet d'optimiser le volume occupé par le capteur 55 dans le deuxième espace 91 : ledit capteur étant préférentiellement un capteur torique, une implantation « à plat » dudit capteur permet de minimiser la distance entre le plan d'interface 9 et la face arrière 6 sans impacter significativement la distance entre la face amont 3 et la face aval 4. D'autre part, l'orientation du capteur de courant 51 suivant l'axe orienté selon la première direction X sensiblement orthogonale la deuxième direction Y du capteur de courant différentiel 55 minimise l'influence du champ électromagnétique rayonné par le capteur de courant 51 sur le capteur de courant différentiel 55.

La plage de raccordement amont 11 est située au niveau du deuxième espace 91 du boitier 2. Cette disposition associée à l'implantation « à plat » du capteur 55 de courant différentiel 55 favorise la compacité du dispositif de mesure 1 en limitant la longueur et la complexité de la première extrémité 12A de la première portion 12. La plage de raccordement aval 15 est située au niveau du premier espace 90 du boitier. La plage de raccordement amont 11 est alignée selon la première direction X avec la plage de raccordement aval 15.

La première portion de conducteur 12 est préférentiellement constituée d'un conducteur électrique massif, de section sensiblement circulaire de 5 mm de diamètre. Cette portion peut également être réalisée au moyen d'un conducteur électrique de section rectangulaire ou carrée ou encore au moyen de tresse ou toute autre liaison conductrice de l'électricité pouvant suivre une courbure de rayon faible entre les extrémités 12A et 12B. L'extrémité 12B est connectée mécaniquement et électriquement à la première extrémité 13A de la deuxième portion 13 de conducteur.

La deuxième portion de conducteur 13 est préférentiellement de section rectangulaire et forme un coude à angle droit entre les extrémités 13A et 13B. La première extrémité 13A est disposée sensiblement dans le plan d'interface 9. La deuxième extrémité 13B forme une plage plate orientée dans un plan perpendiculaire à la première direction X pour être connectée à la première extrémité 14A de la troisième portion de conducteur 14. La section de la deuxième portion est préférentiellement égale à 12 mm de largeur et 2 mm d'épaisseur La deuxième portion peut également être réalisée au moyen d'un conducteur électrique massif de section circulaire, ovoïde ou carrée ou encore au moyen d'une tresse.

La troisième portion est préférentiellement constituée d'un conducteur électrique massif, préférentiellement de section circulaire de 5 mm de diamètre. La troisième portion traverse le passage 51A formé par le capteur de courant 51 suivant un axe orienté selon la première direction X. Cette troisième portion peut également être réalisée au moyen d'un conducteur électrique massif de section rectangulaire ou carrée ou encore au moyen d'une tresse.

La connexion des différentes portions est réalisée préférentiellement au moyen d'une soudure ou brasure donnant une grande rigidité mécanique et une excellente conductibilité électrique au conducteur de courant 10. L'utilisation d'une section rectangulaire de faible épaisseur en deuxième portion et tout particulièrement dans la première extrémité 13A permet de minimiser la distance entre la face avant 5 et la face arrière 6. En effet cette caractéristique permet de rapprocher le capteur 51 du capteur 55 selon la deuxième direction Y ainsi que le montre clairement la figure 2. En variante, en suivant le même principe, il est possible de minimiser davantage la distance entre la face avant 5 et la face arrière 6 en utilisant une même section rectangulaire de faible épaisseur en première extrémité de la première portion 12A. Les caractéristiques techniques décrites concernant le conducteur de courant 10, tel que représenté en figure 2, sont identiques pour les conducteurs de courant 20 et 30, les portions des conducteurs ayant des longueurs différentes selon les conducteurs de courant.

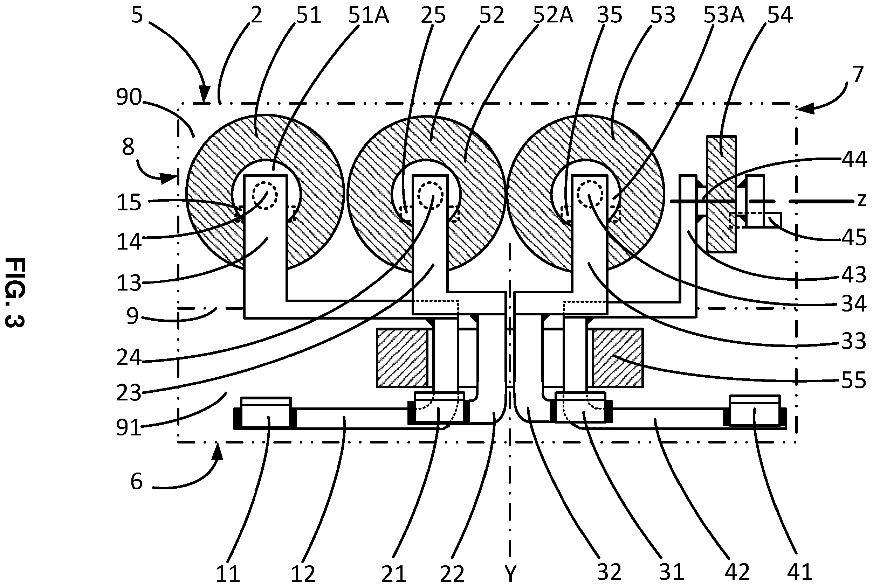

La figure 3 est une représentation du dispositif de mesure, selon une direction face latérale droite - face latérale gauche, montrant un agencement des plages de raccordement selon le mode de réalisation préférentiel de l'invention, c'est-à-dire pour un dispositif de mesure de courant 1, destiné à une utilisation sur un réseau électrique triphasé avec neutre distribué. Les plages de raccordement amont 21 et 31 des conducteurs de courant 20 et 30 sont situées au niveau du deuxième espace 91 du boitier 2. Les plages de raccordement aval 25 et 35 sont situées au niveau du premier espace 90 du boitier 2. Les conducteurs de courant 20 et 30 comportent une première portion, respectivement 22 et 32 préférentiellement constituée d'un conducteur électrique massif. Les premières extrémités des premières portions 22 et 32 sont reliées électriquement respectivement aux plages de raccordement amont 21 et 31. Les deuxièmes extrémités des premières portions 22 et 32 sont connectées mécaniquement et électriquement respectivement aux premières extrémités 23A et 33A des deuxièmes portions 23 et 33 de conducteur. Les deuxièmes portions de conducteur 23 et 33 sont de section rectangulaire et forment un coude à angle droit respectivement entre les extrémités 23A et 23B et 33A et 33B. Les premières extrémités 23A et 33A sont disposées sensiblement dans le plan d'interface. Les deuxièmes extrémités 23B et 33B forment une plage plate orientée dans un plan perpendiculaire à la première direction X pour être connectée respectivement aux premières extrémités 24A et 34A des troisièmes portions de conducteur 24 et 34.

Les troisièmes portions de conducteur 24 et 34 sont préférentiellement de section circulaire et traversent respectivement le passage 52A et 53A formé par les capteurs de courant 52 et 53 suivant un axe orienté selon la première direction X. De même que pour le conducteur 10, la connexion des différentes portions des conducteurs de courant 20 et 30 sont réalisées préférentiellement au moyen d'une soudure ou brasure. Les premières portions respectivement 12, 22, 32 des conducteurs 10, 20, 30 forment un coude entre leurs extrémités respectives. Le capteur de courant différentiel 55 forme un passage 55A traversé par les secondes extrémités 12B, 22B, 32B suivant un axe orienté selon la deuxième direction Y, dans le sens face avant 5 - face arrière 6. Les troisièmes portions de conducteur 14, 24 et 34 sont parallèles entre elles. Les deuxième extrémité 13B, 23B, 33B des deuxièmes portions 13, 23, 33 sont disposées dans un même plan.

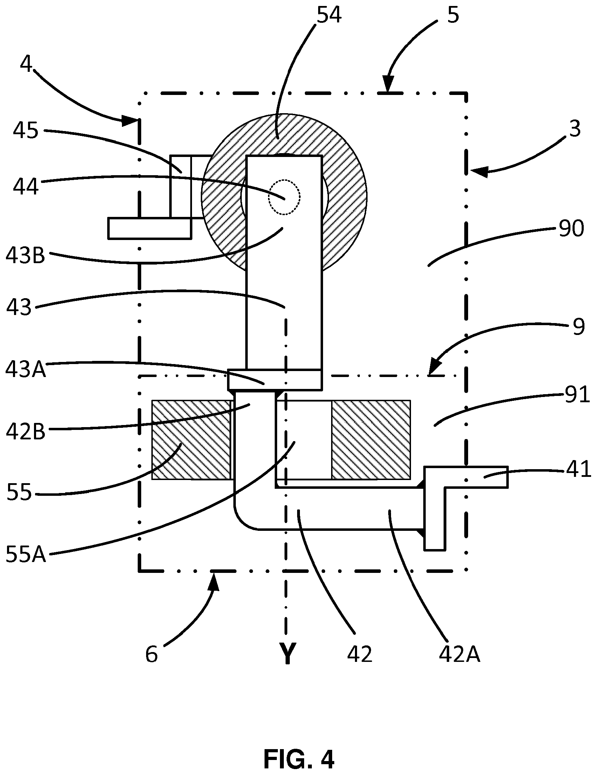

Le conducteur de courant 40 est préférentiellement destiné à la mesure du courant dans la ligne de neutre. En complément à la figure 3, la figure 4 représente schématiquement, selon une direction face amont - face aval, l'agencement des plages de raccordement amont 41 et aval 45, du conducteur de courant 40 et des capteurs de courant 54 et 55 afin de montrer les particularités dudit conducteur de courant par rapport aux autres conducteurs de courant 10, 20 et 30. Le conducteur de courant 40 assure la liaison électrique entre la plage de raccordement amont 41 et la plage de raccordement aval 45. Le conducteur de courant 40 est constitué de trois portions : une première portion 42, une deuxième portion 43 et une troisième portion 44. La première portion de conducteur 42 est constituée au moyen d'un conducteur préférentiellement massif, de la même façon que les premières portions des conducteurs 10, 20 et 30. La première portion 42 forme un coude entre ses deux extrémités 42A et 42B. Le capteur de courant différentiel 55 forme un passage 55A traversé par la seconde extrémité 42B de la première portion 42 du conducteur de courant 40. La deuxième portion de conducteur 43 est de section rectangulaire et forme un coude à angle droit entre les extrémités 43A et 43B. La première extrémité 43A est disposée sensiblement dans le plan d'interface 9, et connectée à la seconde extrémité 42B de la première portion 42. La deuxième extrémité 43B de la deuxième portion 43 forme une plage plate orientée dans un plan parallèle à la première direction X pour être connectée à une première extrémité 44A de la troisième portion de conducteur 44. Le quatrième capteur de courant 54 est disposé autour de la troisième portion de conducteur neutre 44 pour former un passage du conducteur de courant 54A suivant un axe orienté selon une troisième direction Z, dans un sens première face latérale 7 - deuxième face latérale 8. La plage de raccordement aval 45 est connectée à une seconde extrémité 44B de la troisième portion de conducteur neutre 44. Ladite plage de raccordement 45 est coudée selon la première direction X pour être connectée à la deuxième extrémité 44B puis selon la troisième direction Z afin d'être orientée dans le même plan que les autres plages de raccordement aval 15, 25 et 35. Le capteur de courant 54, destiné à la mesure du courant dans la ligne de neutre, est préférentiellement de taille inférieure à la taille des capteurs de courant 51, 52 et 53. L'orientation selon la troisième direction Z du passage du conducteur de courant 54A permet un aménagement d'espace entre le capteur 54 et la première face latérale 7 utilisable pour implanter, par exemple, des cartes électroniques.

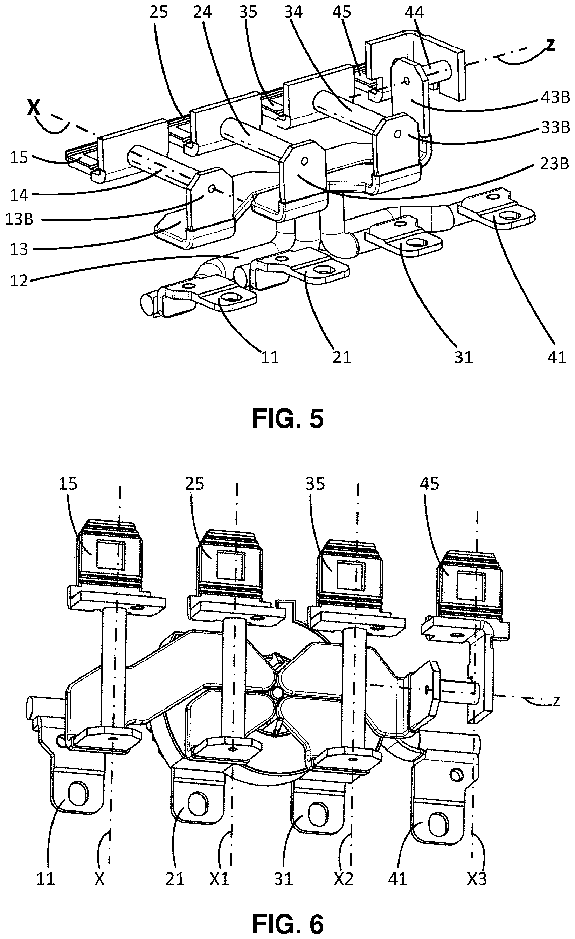

La figure 5 représente une vue en perspective du dispositif de mesure de courant, vue sous le même angle que la figure 1, le dispositif ne comportant pas la représentation de capteurs de courant afin de montrer clairement l'agencement des conducteurs de courant ainsi que la première direction X et la troisième direction Z.

La figure 6 représente une vue en perspective du dispositif de mesure de courant afin d'illustrer un alignement entre les plages de raccordement amont respectivement 11, 21, 31, 41 et les plages de raccordement aval respectivement 15, 25, 35, 45. Chaque plage de raccordement amont 11, 21, 31, 41 est alignée suivant un axe orienté selon la première direction X avec respectivement chaque plage de raccordement aval 15, 25, 35, 45 avec laquelle elle est reliée respectivement par un conducteur de courant 10, 20, 30, 40. Ainsi, sur la figure 6, les plages 11 et 15 sont alignées suivant un axe orienté selon la première direction X, les plages 21 et 15 sont alignées suivant un axe X1 orienté selon la première direction X, les plages 31 et 15 sont alignées suivant un axe X2 orienté selon la première direction X et les plages 41 et 45 sont alignées suivant un axe X3 orienté selon la première direction X. Les axes X, X1, X2 et X3 sont parallèles entre eux. Préférentiellement, la première direction X est parallèle à la première face latérale 7 ou à la deuxième face latérale 8. Cette caractéristique permet, d'avoir une même distance d'entre-axe, appelée aussi « pas » de raccordement, entre les plages de raccordement amont consécutives 11, 21, 31, 41 et entre les plages de raccordement aval consécutives 15, 25, 35, 45. L'interchangeabilité entre des dispositifs de mesure de courant 1 ayant des performances ou des fonctions modulables ou encore l'association avec des dispositifs de coupure 71 aux performances techniques différentes est ainsi facilitée.

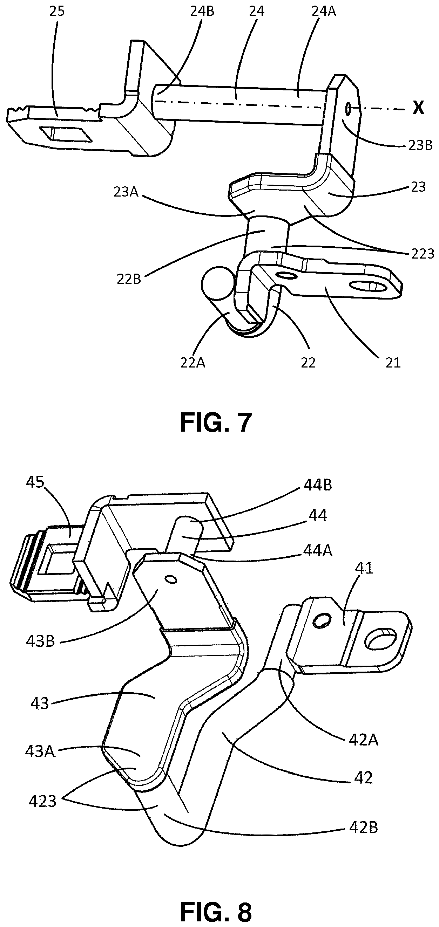

La figure 7 représente une vue détaillée, en perspective et selon un mode de réalisation préférentiel, du conducteur de courant 20 afin de montrer les différentes portions constituantes. La figure 8 représente une vue détaillée, en perspective et selon un mode de réalisation préférentiel, du conducteur 40, destiné à être connecté à une ligne de neutre de l'installation électrique, afin de montrer clairement les différentes portions constituantes.

Préférentiellement, la section des première, deuxième et troisième portion de chaque conducteur (12, 13, 14, 22, 23, 24, 32, 33 et 34) est de surface sensiblement identique afin de répartir les zones d'échauffement tout au long de chaque conducteur de courant en évitant une création de point chaud.

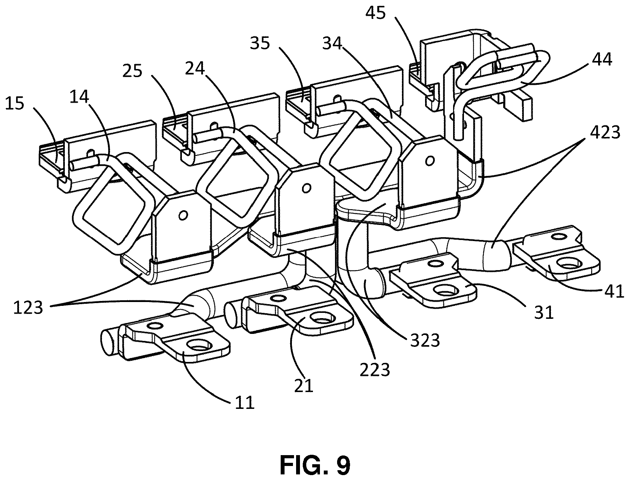

Le dispositif de mesure de courant 1 est préférentiellement destiné à la mesure de courants circulant dans les phases ou le neutre compris entre 25 Ampères et 160 Ampères, mais peut être adapté à la mesure de courants d'amplitude différentes. Par exemple, pour effectuer une mesure de courant d'amplitude 25 Ampères en utilisant des capteurs de courant 51, 52, 53 et 54 dimensionnés pour mesurer des courants plus élevés, il est avantageux de faire traverser deux fois chaque troisième portion de conducteur 14, 24, 34, 44 respectivement dans chaque passage 51A, 52A, 53A et 54A formé par respectivement chaque capteur de courant 51, 52, 53 et 54. Ainsi le signal délivré par les capteurs de courant 51, 52, 53 et 54 est deux fois plus élevé ce qui accroit la précision de mesure. La figure 9 représente une vue en perspective du dispositif de mesure de courant, similaire à la figure 4, pour illustrer une double traversée des troisièmes portions des conducteurs de courant dans les capteurs. Dans le cas d'un calibre nominal de mesure égal à 25 Ampères, la section des troisièmes portions de conducteur 14, 24, 34, 44 peut être plus faible que pour des calibres supérieurs. Le matériau conducteur, préférentiellement du cuivre ou de l'acier cuivré, utilisé pour lesdites troisièmes portions, est recourbé en forme de boucle pour traverser deux fois le passage du capteur de courant respectif. Pour faciliter la réalisation industrielle, la première extrémité 44A et la deuxième extrémité 44B de la troisième portion de conducteur 44 sont formées séparément, agencées avec le capteur de courant 44 pour effectuer une double traversée du capteur de courant 44 puis la première extrémité 44A et la deuxième extrémité 44B sont soudées entre elles pour former la troisième portion 44.

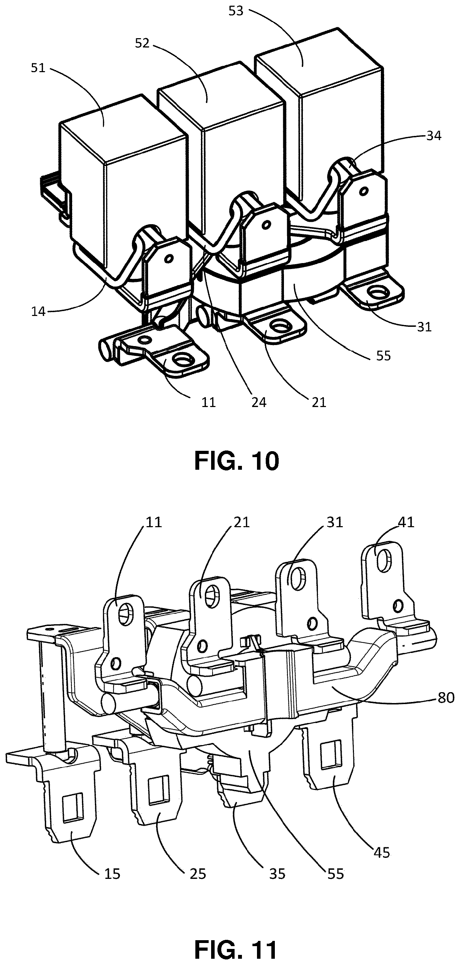

Le dispositif de mesure de courant peut être adapté facilement à une variante tripolaire : la ligne de neutre n'étant pas distribuée, la plage de raccordement amont 41, la plage de raccordement aval 45, le conducteur de courant 40 et le capteur de courant 54 sont absents. Le capteur de courant différentiel 55 forme un passage 55A traversé par les secondes extrémités 12B, 22B, 32B des conducteurs de courant 10, 20 et 30. La figure 10 représente une vue en perspective d'un dispositif de mesure de courant tripolaire comportant une double traversée des troisièmes portions 14, 24, 34 des conducteurs de courant 10, 20, 30 dans les capteurs 51, 52 et 53.

Afin de garantir une tenue diélectrique entre les conducteurs de courant, les premières et deuxièmes portions des conducteurs de courant 10, 20, 30, 40 sont revêtues d'une protection isolante, préférentiellement un revêtement époxy, après un assemblage des premières et deuxièmes portions. Les extrémités 12A, 22A, 32A, 42A et les extrémités 13B, 23B, 33B et 43B sont épargnées de revêtement isolant afin de recevoir une soudure au cours d'un procédé de fabrication. Enfin, un croisillon 80 en matière isolante recouvre les premières extrémités 12A, 22A, 32A, 42A des premières portions afin de maintenir les conducteurs de courant 10, 20, 30, 40 dans une position prédéfinie favorisant la manutention et le montage du dispositif de mesure de courant 1 dans le boitier 2. La figure 11 représente le dispositif de mesure 1 comportant le croisillon 80.

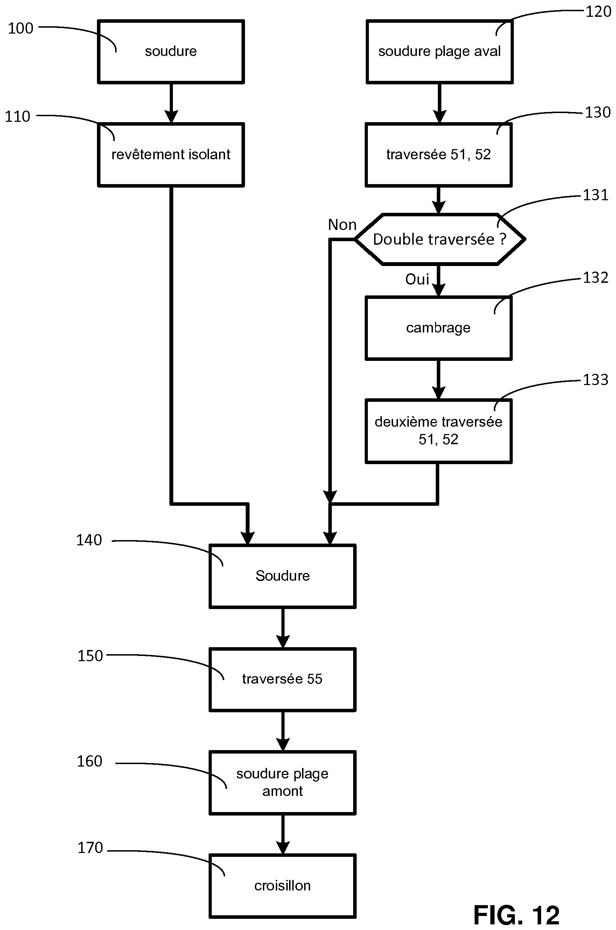

L'invention porte également sur un procédé de fabrication d'un dispositif de mesure de courant 1. Ledit procédé, représenté sous forme d'un organigramme en figure 12, peut être utilisé pour fabriquer un dispositif de mesure de courant adapté à un réseau électrique comportant au moins deux phases et donc comportant au moins deux conducteurs de courant 10, 20. Pour un dispositif de mesure de courant adapté à un réseau électrique triphasé avec neutre, c'est-à-dire comportant quatre conducteurs de courant 10, 20, 30 et 40, le procédé comporte les étapes suivantes :
- la soudure 100 de la première extrémité 13A de la deuxième portion de conducteur 13 à la seconde extrémité 12B de la première portion de conducteur 12 pour former un premier segment de conducteur de courant 123 puis, respectivement et de la même façon, une soudure de la première extrémité 23A, 33A, 43A de chaque deuxième portion de conducteur 23, 33, 43 à chaque seconde extrémité 22B, 32B, 42B de chaque première portion de conducteur 22, 32, 42 pour former respectivement un deuxième, troisième et quatrième segment de chaque conducteur de courant 223, 323, 423,
- le dépôt 110 d'un revêtement isolant sur chaque segment de conducteur 123, 223, 323, 423 pour assurer l'isolation électrique, les premières extrémités 12A, 22A, 32A, 42A et les deuxièmes extrémités 12B, 22B, 32B et 42B de chacun desdits segments de conducteurs étant épargnées de revêtement pour recevoir une soudure ultérieurement,
- la soudure 120 respectivement de chaque plage de raccordement aval 15, 25, 35, 45 à chaque deuxième extrémité 14B, 24B, 34B, 44B de chaque troisième portion 14, 24, 34, 44,
- la traversée 130 respectivement de chaque troisième portion 14, 24, 34, 44 de chacun des conducteurs dans le passage 51A, 52A, 53A et 54A formé respectivement par le capteur de courant 51, 52, 53, 54.

Le procédé est adapté à la fabrication d'un dispositif de mesure de courant 1 comportant une simple ou une double traversée des troisièmes portions des conducteurs de courant dans les capteurs de courant 51, 52, 53, 54. Une étape de sélection 131 sélectionne une variante de fabrication simple traversée ou double traversée et, dans le cas d'une double traversée, une étape de cambrage 132 des troisièmes portions des conducteurs de courant 14, 24, 34, 44 est réalisée pour former une boucle respectivement autour de chaque capteur 51, 52, 53, 54 puis une deuxième traversée 133 de chaque troisième portion 14, 24, 34, 44 de chacun des conducteurs est réalisée respectivement dans le passage 51A, 52A, 53A et 54A et le procédé est poursuivi par l'étape 140. Si le dispositif de mesure de courant 1 comporte une simple traversée des troisièmes portions des conducteurs de courant, le procédé passe directement de l'étape 131 à l'étape 140.

Le procédé se poursuit par les étapes suivantes :
- la soudure 140 respectivement de chaque première extrémité 14A, 24A, 34A, 44A de chaque troisième portion 14, 24, 34 44 à chaque segment de conducteur 123, 223, 323, 423 au niveau de la deuxième extrémité 13B, 23B, 33B et 43B des deuxièmes portions 13, 23, 33 et 43,
- la traversée 150 des premières extrémités 12A, 22A, 32A, 42A des segments de conducteur dans le passage commun 55A formé par le capteur de courant différentiel 55,
- la soudure 160 respectivement de chaque plage de raccordement amont 11, 21, 31, 41 à chaque première extrémité 12A, 22A, 32A, 42A de chaque segment de conducteur 123, 223, 323, 423, et
- le positionnement 170 d'un croisillon 80 pour maintenir les premières extrémités 12A, 22A, 32A, 42A des premières portions dans une position prédéfinie favorisant la manutention et l'implantation dans le boitier 2 du dispositif de mesure de courant 1.

L'ensemble des étapes 100, 110 peut être mené parallèlement, tel que représenté en figure 12, ou en série avec l'ensemble des étapes 120, 130, 131, 132, 133. Préférentiellement, les étapes 150 et 160 sont réalisées séquentiellement sur chacun des conducteurs de courant et exécutées dans l'ordre spécifique suivant : d'abord le conducteur de courant 20 puis le conducteur de courant 30 puis conducteur de courant 10 et enfin le conducteur de courant 40 (ligne de neutre). A titre d'illustration, les étapes 150 et 160 réalisées pour le conducteur de courant 20 comportent les opérations suivantes :
- à l'étape 150, la traversée de la première extrémité 22A du segment de conducteur 223 dans le passage commun 55A formé par le capteur de courant différentiel 55
- à l'étape 160, la soudure de la plage de raccordement amont 21 à la première extrémité 22A, du segment de conducteur 223.

La réalisation du dispositif de mesure de courant 1 est la plus simple quand l'ordre et le séquencement des étapes décrits précédemment sont suivis.

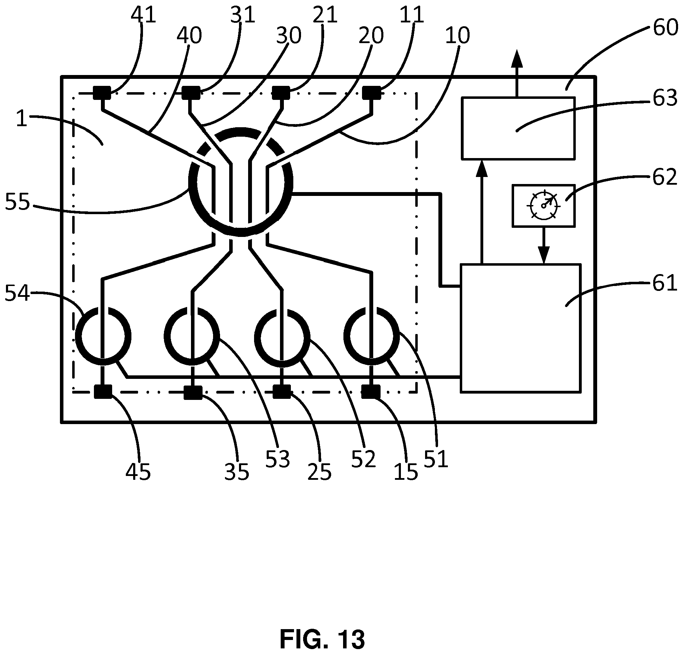

Le dispositif de mesure de courant 1 de l'invention est particulièrement adapté pour une implantation dans un module de protection 60 contre les défauts électriques appelé aussi « déclencheur ». La figure 13 est une représentation synoptique d'un tel module de protection 60. Ledit module comporte :
- une unité de traitement 61, comportant préférentiellement des circuits de numérisation de signaux électriques et de calculs, par exemple un ou plusieurs microprocesseurs ou circuits équivalents,
- un actionneur 63 pour actionner le dispositif de coupure de courant électrique 71, et
- un dispositif de réglage 62 relié à l'unité de traitement 61, ledit dispositif de réglage 62 étant agencé pour régler au moins un ou plusieurs seuils de déclenchement. Le réglage d'un seuil de déclenchement peut être effectué au cours du cycle de fabrication du module de protection en usine et dans ce cas n'est pas réglable ultérieurement, en particulier, l'utilisateur du module de protection n'y a pas accès. Préférentiellement, un commutateur ou un clavier associé à un écran disposé sur la face avant du module de protection permettent un réglage du seuil de déclenchement par l'utilisateur. Un premier seuil de déclenchement SD est destiné à une protection contre les surintensités dans l'installation électrique. Par exemple, le premier seuil a pour valeur 25, 50, 100 ou 160 Ampère. Un deuxième seuil SDD est destiné à une protection contre les courants différentiels. Par exemple, le deuxième seuil SDD a pour valeur 30 mA, 100 mA, 300 mA, 1 Ampère ou 5 Ampère. Le module de protection 60 comporte un dispositif de mesure de courant 1 tel que décrit précédemment. Selon le besoin de l'utilisateur, ledit module comporte au moins deux capteurs de courant 51, 52, et préférentiellement un troisième capteur 53 pour une utilisation destinée à un réseau triphasé ou quatre capteurs de courant 51, 52, 53, 54 pour une utilisation destinée à un réseau triphasé avec une ligne neutre distribuée. Le module 60 comporte un capteur de courant différentiel 55, et au moins deux conducteurs de courant 10, 20 reliés électriquement aux plages de raccordement amont 11, 21 et aux plages de raccordement aval 15, 25 et préférentiellement un troisième conducteur de courant 30 pour une utilisation destinée à un réseau triphasé et un quatrième conducteur de courant 40 pour une utilisation destinée à un réseau triphasé avec une ligne neutre distribuée, lesdits conducteurs étant reliés électriquement respectivement aux plages de raccordement amont 11, 21, 31, 41 et aux plages de raccordement aval 15, 25, 35, 45.

L'unité de traitement 61 est connectée aux capteurs de courant 51, 52, 53 et 54 et au capteur de courant différentiel 55 pour former :
- au moins une mesure M du courant circulant dans chacun des conducteurs de courant 51, 52, 53, 54 et
- une mesure du courant différentiel MD sur l'ensemble des conducteurs de courant 51,52, 53 et 54, l'unité de traitement 61 étant agencée pour activer l'actionneur 63 pour actionner le dispositif de coupure de courant électrique 71 quand au moins une mesure de courant M ou quand la mesure du courant différentiel MD est supérieure respectivement à au moins un seuil de déclenchement SD ou SDD.

Le module de protection 60 contre les défauts électriques est destiné à coopérer avec le dispositif de coupure de courant électrique 71 afin d'assurer une protection de l'installation électrique dans le cas d'un défaut d'origine électrique. L'association du module de protection 60 et du dispositif de coupure de courant électrique 71 forme un disjoncteur 70. Le module de protection étant capable de mesurer le courant différentiel MD et d'activer le dispositif de coupure de courant électrique 71 quand la mesure du courant différentiel MD est supérieure à un seuil de déclenchement SDD, le disjoncteur 70 est de type différentiel.

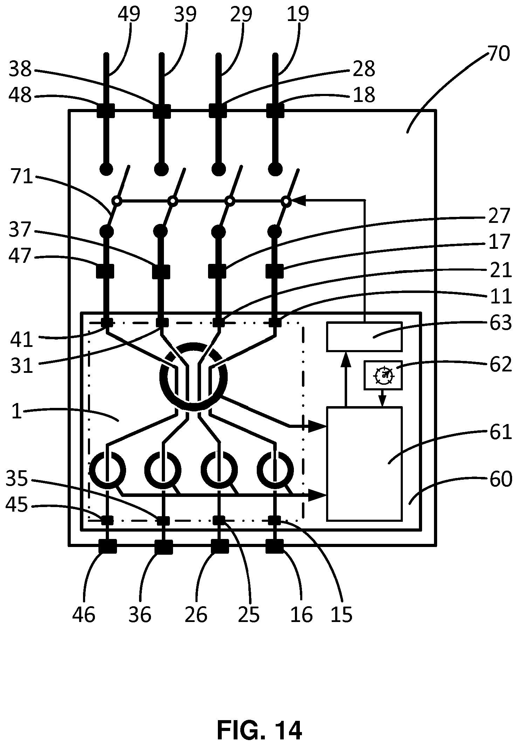

La figure 14 représente un synoptique d'un tel disjoncteur différentiel 70. Le disjoncteur est connecté à au moins deux lignes électriques 19, 29, 39, 49, et comporte :
- au moins deux bornes de raccordement amont 18, 28, 38, 48 pour connecter les, au moins deux, lignes électriques 19, 29, 39, 49,
- au moins deux bornes de raccordement interne 17, 27, 37, 47 et
- un dispositif de coupure de courant électrique 71 comportant des contacts permettant d'établir ou d'interrompre le courant circulant entre les, au moins deux, bornes de raccordement amont 18, 28, 38, 48 et les, au moins deux, bornes de raccordement interne 17, 27, 37, 47.

Les plages de raccordement amont 11, 21, 31, 41 du module de protection 60 sont connectées respectivement aux bornes de raccordement interne 17, 27, 37, 47 du dispositif de coupure de courant électrique 71. Les plages de raccordement aval 15, 25, 35, 45 du module de protection 60 sont connectées ou font partie de bornes d'utilisation 16, 26, 36, 46 destinées à connecter des charges électriques. L'actionneur 63 du module de protection 60 est relié au dispositif de coupure de courant électrique 71 préférentiellement par une liaison mécanique et, en cas de dépassement d'un seuil de déclenchement SD ou SDD, le module de protection 60 émet une commande au moyen de l'actionneur 63 pour actionner le dispositif de coupure de courant électrique 71 afin d'interrompre la circulation du courant dans les lignes électriques 19, 29, 39, 49.

L'implantation particulière du capteur 55 dans le premier espace 90 et des capteurs de courant 51, 52, 53, 54 dans le second espace 91, la disposition des plages de raccordement amont 11, 21, 31 et 41 au niveau du deuxième espace 91 et l'utilisation d'une section rectangulaire de faible épaisseur en première extrémité 13A, 23A, 33A, 43A des secondes portions de conducteur permettent de minimiser la distance entre la face avant 5 et la face arrière 6 et entre la face amont 3 et la face aval 4 ce qui favorise la compacité du dispositif de mesure 1. Ainsi, il est possible de disposer d'une fonction de protection différentielle dans un boitier 2 de taille et de localisation des raccordements identiques à un boitier ne disposant jusqu'alors que d'une fonction de protection en surintensité. Disposer de ces fonctionnalités dans un même produit est particulièrement intéressant pour l'utilisateur : cela permet une interchangeabilité dudit module de protection en fonction du besoin de l'utilisateur, ce dernier pouvant alors dimensionner un tableau électrique pour l'équiper par la suite d'appareils de protection disposant ou ne disposant pas de protection différentielle sans avoir à modifier les raccordements ou le montage mécanique dans le tableau.

## Revendications

1. Dispositif de mesure de courant (1), agencé pour être implanté dans un boîtier (2) de forme sensiblement parallélépipédique comportant une face amont (3) opposée à une face aval (4), une face avant (5) opposée à une face arrière (6), et une première face latérale (7) opposée à une deuxième face latérale (8), ledit dispositif de mesure de courant (1) comportant :
- au moins deux plages de raccordement amont (11, 21), destinées à être raccordées électriquement à des plages de raccordement (17, 27) d'un dispositif de coupure de courant électrique (71) pour la protection de, au moins deux, lignes électriques (19, 29),
- au moins deux plages de raccordement aval (15, 25), destinées à être raccordées électriquement à des bornes d'utilisation (16, 26),
- au moins deux conducteurs de courant (10, 20), chaque conducteur de courant étant agencé pour relier électriquement respectivement une plage de raccordement amont (11, 21) à une plage de raccordement aval (15, 25),
- au moins deux capteurs de courant (51, 52), chaque capteur de courant étant disposé respectivement autour d'un conducteur de courant (10, 20) pour former respectivement un passage (51A, 52A) du conducteur de courant suivant un axe orienté selon une première direction (X) dans le sens face amont (3)-face aval (4), et
- un capteur de courant différentiel (55) disposé autour de l'ensemble des, au moins deux, conducteurs de courant (10, 20) pour former un passage commun (55A) aux conducteurs de courant (10, 20) suivant un axe orienté selon une deuxième direction (Y) dans le sens face avant (5)-face arrière (6),
chaque plage de raccordement amont (11, 21) étant alignée suivant un axe orienté selon la première direction (X) avec respectivement chaque plage de raccordement aval (15, 25) à laquelle ladite plage de raccordement amont (11, 21) est reliée respectivement par un conducteur de courant (10, 20),
ledit dispositif de mesure de courant (1) étant **caractérisé en ce qu'**il est destiné à la mesure des courants circulant dans trois lignes de phase et une ligne de neutre d'un réseau électrique triphasé, et qu'il comprend un premier, un deuxième et un troisième capteur de courant (51, 52, 53), chaque capteur de courant étant destiné à mesurer un courant circulant dans chacune des phases, et comporte un quatrième capteur de courant (54) destiné à mesurer un courant dans la ligne de neutre, le quatrième capteur de courant (54) étant disposé autour d'un conducteur neutre (40) pour former un passage du conducteur de courant (54A) suivant un axe orienté selon une troisième direction (Z) dans un sens première face latérale (7) -deuxième face latérale (8)

2. Dispositif de mesure de courant (1) selon la revendication 1 **caractérisé en ce que** les capteurs de courant (51, 52) d'une part et le capteur de courant différentiel (55) d'autre part sont implantés respectivement dans des espaces (90, 91) superposés entre la face avant (5) et la face arrière (6) de telle sorte que :
- les capteurs de courant (51, 52) sont disposés dans un premier espace (90) du boitier (2), ledit premier espace (90) étant délimité par la face avant (5), la première face latérale (7), la deuxième face latérale (8), la face amont (3), la face aval (4) et un plan d'interface (9) situé entre la face avant (5) et la face arrière (6), et
- le capteur de courant différentiel (55) est disposé dans un deuxième espace (91) du boitier (2), ledit deuxième espace (91) étant délimité par le plan d'interface (9), la première face latérale (7), la deuxième face latérale (8), la face amont (3), la face aval (4) et la face arrière (6).

3. Dispositif de mesure de courant (1) selon la revendication 2 **caractérisé en ce que** les plages de raccordement amont (11, 21) sont situées au niveau du deuxième espace (91) du boitier.

4. Dispositif de mesure de courant (1) selon l'une des revendications 2 ou 3 **caractérisé en ce que** les plages de raccordement aval (15, 25) sont situées au niveau du premier espace (90) du boitier.

5. Dispositif de mesure de courant (1) selon l'une quelconque des revendications 1 à 4 **caractérisé en ce que** chaque conducteur de courant (10, 20) est composé de trois portions :
- une première portion de conducteur (12, 22) connectée électriquement, à une première de ses extrémités (12A, 22A), à la plage de raccordement amont (11, 21), ladite première portion de conducteur (12, 22) étant agencée pour traverser le passage commun (55A) du capteur de courant différentiel (55) et agencée pour être connectée électriquement, à une deuxième de ses extrémités (12B, 22B), à une première extrémité (13A, 23A) d'une deuxième portion (13, 23) de conducteur,
- la deuxième portion de conducteur (13, 23) de section rectangulaire, connectée électriquement, à une première de ses extrémités (13A, 23A), à la deuxième extrémité (12B, 22B) de la première portion de conducteur (12, 22), ladite première extrémité (13A, 23A) étant disposée sensiblement dans le plan d'interface (9) et coudée à une seconde de ses extrémités pour former une plage plate (13B, 23B) orientée dans un plan perpendiculaire à la première direction (X), et
- une troisième portion de conducteur (14, 24), connectée électriquement, à une première de ses extrémités (14A, 24A), à la plage plate (13B, 23B) formée par la seconde extrémité de la deuxième portion de conducteur (13, 23), ladite troisième portion de conducteur (14, 24), étant agencée pour traverser le passage (51A, 52A) d'un capteur de courant (51, 52) et agencée pour être connectée électriquement, à une deuxième de ses extrémités (14B, 24B), à la plage de raccordement aval (15, 25).

6. Dispositif de mesure de courant (1) selon la revendication 5 **caractérisé en ce que** chaque troisième portion de conducteur (14, 24) traverse au moins deux fois le passage du capteur de courant (51A, 52A) qui l'entoure en formant une boucle.

7. Dispositif de mesure de courant (1) selon la revendication 5, **caractérisé en ce que** la section de la première, deuxième et troisième portion de chaque conducteur (12, 13, 14, 22, 23, 24) est de surface sensiblement identique.

8. Procédé de fabrication d'un dispositif de mesure de courant (1) selon l'une des revendications précédentes comportant les étapes suivantes :
- la soudure (100) de chaque première extrémité (13A, 23A) de chaque deuxième portion de conducteur (13, 23) à chaque seconde extrémité (12B, 22B) de chaque première portion de conducteur (12, 22) pour former un segment de chaque conducteur de courant (123, 223, 323, 423),
- le dépôt (110) d'un revêtement isolant sur chaque segment de conducteur (123, 223, 323, 423) pour assurer l'isolation électrique de chaque segment de conducteur (123, 223, 323, 423), des premières et deuxièmes extrémités (12A, 13B, 22A, 23B) de chacun desdits segments de conducteurs étant épargnées de revêtement pour recevoir une soudure ultérieurement,
- la soudure (120) respectivement de chaque plage de raccordement aval (15, 25, 35, 45) à chaque deuxième extrémité (14B, 24B, 34B, 44B) de chaque troisième portion (14, 24, 34, 44),
- la traversée (130) respectivement de chaque troisième portion (14, 24, 34, 44) de chacun des conducteurs dans le passage (51A, 52A, 53A et 54A) formé respectivement par le capteur de courant (51, 52, 53, 54),
- la sélection (131) d'une variante de fabrication simple traversée ou double traversée et, dans le cas d'une double traversée ;
- une étape de cambrage (132) des troisièmes portions des conducteurs de courant (14, 24, 34, 44) pour former une boucle autour de respectivement chaque capteur (51, 52, 53, 54), et
- une deuxième traversée (133) de chaque troisième portion (14, 24, 34, 44) de chacun des conducteurs dans le passage (51A, 52A, 53A et 54A),
- la soudure (140) respectivement de chaque première extrémité (14A, 24A, 34A, 44A) de chaque troisième portion (14, 24, 34 44) à chaque segment (123, 223, 323, 423) au niveau de la deuxième extrémité (13B, 23B, 33B et 43B) des deuxièmes portions (13, 23, 33 et 43),
- la traversée (150) des premières extrémités (12A, 22A, 32A, 42A) des segments de conducteur dans le passage commun (55A) formé par le capteur de courant différentiel (55),
- la soudure (160) respectivement de chaque plage de raccordement amont (11, 21, 31, 41) à chaque première extrémité (12A, 22A, 32A, 42A) de chaque segment de conducteur (123, 223, 323, 423), et
- le positionnement (170) d'un croisillon (80) pour maintenir les premières extrémités (12A, 22A, 32A, 42A) des premières portions dans une position prédéfinie.

9. Module de protection (60) contre les défauts électriques destiné à coopérer avec un dispositif de coupure de courant électrique (71), ledit module de protection comportant :
- une unité de traitement (61),
- un actionneur (63) pour actionner le dispositif de coupure de courant électrique (71), et
- un dispositif de réglage (62) relié à l'unité de traitement (61), ledit dispositif de réglage (62) étant agencé pour régler au moins un premier seuil de déclenchement (SD) et/ou un second seuil de déclenchement (SDD),
ledit module de protection contre les défauts électriques étant **caractérisé en ce qu'**il comporte un dispositif de mesure de courant (1) selon l'une quelconque des revendications 1 à 7, ledit dispositif de mesure comportant :
- au moins deux capteurs de courant (51,52),
- un capteur de courant différentiel (55), et
- au moins deux conducteurs de courant (10, 20) reliés électriquement à des plages amont (11, 21) et des plages aval (15,25),
l'unité de traitement (61) étant connectée aux capteurs de courant (51,52) et au capteur de courant différentiel (55) pour former :
- au moins une mesure (M) du courant circulant dans chacun des conducteurs de courant (51,52), et
- une mesure du courant différentiel (MD) sur l'ensemble des conducteurs de courant (51,52), l'unité de traitement (61) étant agencée pour activer l'actionneur (63) pour actionner le dispositif de coupure de courant électrique (71) quand la mesure de courant (M) est supérieure au premier seuil de déclenchement (SD) ou quand la mesure du courant différentiel (MD) est supérieure au second seuil de déclenchement (SDD).

10. Disjoncteur différentiel (70) destiné à assurer une protection contre des défauts électriques d'un circuit électrique comportant au moins deux lignes électriques (19, 29), ledit disjoncteur comportant :
- au moins deux bornes de raccordement amont (18, 28) pour connecter au moins les deux lignes électriques (19, 29),
- au moins deux bornes de raccordement interne (17, 27), et
- un dispositif de coupure de courant électrique (71),
**caractérisé en ce que** ledit disjoncteur comporte, en outre, un module de protection (60) contre les défauts électriques selon la revendication 9,
- le dispositif de coupure de courant électrique (71) étant connecté entre les, au moins deux, bornes de raccordement amont (18, 28) et les, au moins deux, bornes de raccordement interne (17, 27), ledit dispositif de coupure de courant électrique (71) comportant des contacts permettant d'établir ou d'interrompre le courant circulant entre les, au moins deux, bornes de raccordement amont (18, 28) et les, au moins deux, bornes de raccordement interne (17, 27),
- les, au moins deux, bornes de raccordement interne (17, 27) étant connectées aux, au moins deux, plages amont (11, 21) du module de protection (60),
- le dispositif de coupure de courant électrique (71) du disjoncteur différentiel (70) étant connecté et agencé pour recevoir et exécuter une commande émise par un actionneur (63) du module de protection (60).

## Patentansprüche

1. Strommessvorrichtung (1), eingerichtet, um in ein Gehäuse (2) von im Wesentlichen parallelepipedischer Form eingesetzt zu werden, das eine vorgelagerte Seite (3) gegenüber einer nachgelagerten Seite (4), eine Vorderseite (5) gegenüber einer Rückseite (6) und eine erste Seitenfläche (7) gegenüber einer zweiten Seitenfläche (8) aufweist, wobei die Strommessvorrichtung (1) aufweist:
- mindestens zwei vorgelagerte Anschlussbereiche (11, 21), die dazu bestimmt sind, elektrisch an Anschlussbereiche (17, 27) einer Stromabschaltvorrichtung (71) für den Schutz von mindestens zwei elektrischen Leitungen (19, 29) angeschlossen zu werden,
- mindestens zwei nachgelagerte Anschlussbereiche (15, 25), die dazu bestimmt sind, elektrisch an Nutzklemmen (16, 26) angeschlossen zu werden,
- mindestens zwei Stromleiter (10, 20), wobei jeder Stromleiter eingerichtet ist, einen vorgelagerten Anschlussbereich (11, 21) mit einem nachgelagerten Anschlussbereich (15, 25) elektrisch zu verbinden,
- mindestens zwei Stromsensoren (51, 52), wobei jeder Stromsensor um einen Stromleiter (10, 20) herum angeordnet ist, um einen Durchlass (51A, 52A) des Stromleiters entlang einer gemäß einer ersten Richtung (X) von der vorgelagerten Seite (3) zur nachgelagerten Seite (4) ausgerichteten Achse zu bilden, und
- einen Fehlerstromstromsensor (55), der um die Einheit der mindestens zwei Stromleiter (10, 20) herum angeordnet ist, um einen gemeinsamen Durchlass (55A) für die Stromleiter (10, 20) entlang einer gemäß einer zweiten Richtung (Y) von der Vorderseite (5) zur Rückseite (6) ausgerichteten Achse zu bilden,
wobei jeder vorgelagerte Anschlussbereich (11, 21) entlang einer gemäß der ersten Richtung (X) ausgerichteten Achse mit jedem nachgelagerten Anschlussbereich (15, 25) fluchtend ausgerichtet ist, mit dem der vorgelagerte Anschlussbereich (11, 21) je durch einen Stromleiter (10, 20) verbunden ist,
wobei die Strommessvorrichtung (1) **dadurch gekennzeichnet ist, dass** sie für die Messung der in drei Phasenleitungen und einer Neutralleitung eines elektrischen Dreiphasennetzes fließenden Ströme bestimmt ist, und dass sie einen ersten, einen zweiten und einen dritten Stromsensor (51, 52, 53) enthält, wobei jeder Stromsensor dazu bestimmt ist, einen in jeder der Phasen fließenden Strom zu messen, und einen vierten Stromsensor (54) aufweist, der dazu bestimmt ist, einen Strom in der Neutralleitung zu messen, wobei der vierte Stromsensor (54) um einen Neutralleiter (40) herum angeordnet ist, um einen Durchlass des Stromleiters (54A) entlang einer gemäß einer dritten Richtung (Z) von der ersten Seitenfläche (7) zur zweiten Seitenfläche (8) ausgerichteten Achse zu bilden.

2. Strommessvorrichtung (1) nach Anspruch 1, **dadurch gekennzeichnet, dass** die Stromsensoren (51, 52) einerseits und der Fehlerstromstromsensor (55) andererseits in Räume (90, 91) eingesetzt sind, die zwischen der Vorderseite (5) und der Rückseite (6) übereinander liegen, so dass:
- die Stromsensoren (51, 52) in einem ersten Raum (90) des Gehäuses (2) angeordnet sind, wobei der erste Raum (90) von der Vorderseite (5), der ersten Seitenfläche (7), der zweiten Seitenfläche (8), der vorgelagerten Seite (3), der nachgelagerten Seite (4) und einer Schnittstellebene (9) begrenzt wird, die sich zwischen der Vorderseite (5) und der Rückseite (6) befindet, und
- der Fehlerstromstromsensor (55) in einem zweiten Raum (91) des Gehäuses (2) angeordnet ist, wobei der zweite Raum (91) von der Schnittstellenebene (9), der ersten Seitenfläche (7), der zweiten Seitenfläche (8), der vorgelagerten Seite (3), der nachgelagerten Seite (4) und der Rückseite (6) begrenzt wird.

3. Strommessvorrichtung (1) nach Anspruch 2, **dadurch gekennzeichnet, dass** die vorgelagerten Anschlussbereiche (11, 21) sich im Bereich des zweiten Raums (91) des Gehäuses befinden.

4. Strommessvorrichtung (1) nach einem der Ansprüche 2 oder 3, **dadurch gekennzeichnet, dass** die nachgelagerten Anschlussbereiche (15, 25) sich im Bereich des ersten Raums (90) des Gehäuses befinden.

5. Strommessvorrichtung (1) nach einem der Ansprüche 1 bis 4, **dadurch gekennzeichnet, dass** jeder Stromleiter (10, 20) aus drei Abschnitten besteht:
- einem ersten Leiterabschnitt (12, 22), der an einem ersten seiner Enden (12A, 22A) mit dem vorgelagerten Anschlussbereich (11, 21) elektrisch verbunden ist, wobei der erste Leiterabschnitt (12, 22) eingerichtet ist, den gemeinsamen Durchlass (55A) des Fehlerstromstromsensors (55) zu durchqueren, und eingerichtet ist, an einem zweiten seiner Enden (12B, 22B) mit einem ersten Ende (13A, 23A) eines zweiten Leiterabschnitts (13, 23) elektrisch verbunden zu werden,
- dem zweiten Leiterabschnitt (13, 23) mit rechtwinkligem Querschnitt, der an einem ersten seiner Enden (13A, 23A) mit dem zweiten Ende (12B, 22B) des ersten Leiterabschnitts (12, 22) elektrisch verbunden ist, wobei das erste Ende (13A, 23A) im Wesentlichen in der Schnittstellenebene (9) angeordnet ist, und an einem zweiten seiner Enden gebogen ist, um einen flachen Bereich (13B, 23B) zu formen, der in einer Ebene lotrecht zu der ersten Richtung (X) ausgerichtet ist, und
- einen dritten Leiterabschnitt (14, 24), der an einem ersten seiner Enden (14A, 24A) mit dem vom zweiten Ende des zweiten Leiterabschnitts (13, 23) gebildeten flachen Bereich (13B, 23B) elektrisch verbunden ist, wobei der dritte Leiterabschnitt (14, 24) eingerichtet ist, den Durchlass (51A, 52A) eines Stromsensors (51, 52) zu durchqueren, und eingerichtet ist, an einem zweiten seiner Enden (14B, 24B) mit dem nachgelagerten Anschlussbereich (15, 25) elektrisch verbunden zu werden.

6. Strommessvorrichtung (1) nach Anspruch 5, **dadurch gekennzeichnet, dass** jeder dritte Leiterabschnitt (14, 24) den Durchlass des Stromsensors (51A, 52A), der ihn umgibt, unter Bildung einer Schleife mindestens zweimal durchquert.

7. Strommessvorrichtung (1) nach Anspruch 5, **dadurch gekennzeichnet, dass** der Querschnitt des ersten, zweiten und dritten Abschnitts jedes Leiters (12, 13, 14, 22, 23, 24) im Wesentlichen die gleiche Oberfläche hat.

8. Herstellungsverfahren einer Strommessvorrichtung (1) nach einem der vorhergehenden Ansprüche, das die folgenden Schritte aufweist:
- die Schweißung (100) jedes ersten Endes (13A, 23A) jedes zweiten Leiterabschnitts (13, 23) an jedes zweite Ende (12B, 22B) jedes ersten Leiterabschnitts (12, 22), um ein Segment jedes Stromleiters (123, 223, 323, 423) zu bilden,
- das Aufbringen (110) einer Isolierbeschichtung auf jedes Leitersegment (123, 223, 323, 423), um die elektrische Isolierung jedes Leitersegments (123, 223, 323, 423) zu gewährleisten, wobei erste und zweite Enden (12A, 13B, 22A, 23B) jedes Leitersegments von der Beschichtung ausgenommen werden, um später eine Schweißung zu empfangen,
- die Schweißung (120) jedes nachgelagerten Anschlussbereichs (15, 25, 35, 45) an jedes zweite Ende (14B, 24B, 34B, 44B) jedes dritten Abschnitts (14, 24, 34, 44),
- die Durchquerung (130) jedes dritten Abschnitts (14, 24, 34, 44) jedes der Leiter im vom Stromsensor (51, 52, 53, 54) gebildeten Durchlass (51A, 52A, 53A und 54A),
- die Auswahl (131) einer Herstellungsvariante einfacher Durchquerung oder doppelter Durchquerung, und im Fall einer doppelten Durchquerung:
- einen Schritt der Biegung (132) der dritten Abschnitte der Stromleiter (14, 24, 34, 44), um eine Schleife um jeden Sensor (51, 52, 53, 54) zu bilden, und
- eine zweite Durchquerung (133) jedes dritten Abschnitts (14, 24, 34, 44) jedes der Leiter im Durchlass (51A, 52A, 53A und 54A),
- das Schweißen (140) jedes ersten Endes (14A, 24A, 34A, 44A) jedes dritten Abschnitts (14, 24, 34, 44) an jedes Segment (123, 223, 323, 423) im Bereich des zweiten Endes (13B, 23B, 33B und 43B) der zweiten Abschnitte (13, 23, 33 und 43),
- die Durchquerung (150) der ersten Enden (12A, 22A, 32A, 42A) der Leitersegmente im vom Fehlerstromstromsensor (55) gebildeten gemeinsamen Durchlass (55A),
- die Schweißung (160) jedes vorgelagerten Anschlussbereichs (11, 21, 31, 41) an jedes erste Ende (12A, 22A, 32A, 42A) jedes Leitersegments (123, 223, 323, 423), und
- die Positionierung (170) eines Kreuzstücks (80), um die ersten Enden (12A, 22A, 32A, 42A) der ersten Abschnitte in einer vordefinierten Position zu halten.

9. Schutzmodul (60) gegen elektrische Fehler, das dazu bestimmt ist, mit einer Stromabschaltvorrichtung (71) zusammenzuwirken, wobei das Schutzmodul aufweist:
- eine Verarbeitungseinheit (61),
- einen Betätiger (63), um die Stromabschaltvorrichtung (71) zu betätigen, und
- eine mit der Verarbeitungseinheit (61) verbundene Einstellvorrichtung (62) wobei die Einstellvorrichtung (62) eingerichtet ist, mindestens eine erste Auslöseschwelle (SD) und/oder eine zweite Auslöseschwelle (SDD) einzustellen,
wobei das Schutzmodul gegen elektrische Fehler **dadurch gekennzeichnet ist, dass** es eine Strommessvorrichtung (1) nach einem der Ansprüche 1 bis 7 aufweist, wobei die Messvorrichtung aufweist:
- mindestens zwei Stromsensoren (51, 52),
- einen Fehlerstromstromsensor (55), und
- mindestens zwei Stromleiter (10, 20), die mit vorgelagerten Bereichen (11, 21) und mit nachgelagerten Bereichen (15,25) elektrisch verbunden sind,
wobei die Verarbeitungseinheit (61) mit den Stromsensoren (51,52) und mit dem Fehlerstromstromsensor (55) verbunden ist, um zu bilden:
- mindestens eine Messung (M) des in jedem der Stromleiter (51, 52) fließenden Stroms, und
- eine Messung des Fehlerstromstroms (MD) über die Gesamtheit der Stromleiter (51, 52), wobei die Verarbeitungseinheit (61) eingerichtet ist, den Betätiger (63) zur Betätigung der Stromabschaltvorrichtung (71) zu aktivieren, wenn die Strommessung (M) höher ist als die erste Auslöseschwelle (SD) oder wenn die Messung des Fehlerstroms (MD) höher ist als die zweite Auslöseschwelle (SDD).

10. Fehlerstromschutzschalter (70), der dazu bestimmt ist, einen Schutz gegen elektrische Fehler eines Stromkreises zu gewährleisten, der mindestens zwei elektrische Leitungen (19, 29) aufweist, wobei der Schutzschalter aufweist:
- mindestens zwei vorgelagerte Anschlussklemmen (18, 28), um mindestens die zwei elektrischen Leitungen (19, 29) zu verbinden,
- mindestens zwei innere Anschlussklemmen (17, 27), und
- eine Stromabschaltvorrichtung (71),
**dadurch gekennzeichnet, dass** der Schutzschalter außerdem ein Schutzmodul (60) gegen die elektrischen Fehler nach Anspruch 9 aufweist,
- wobei die Stromabschaltvorrichtung (71) zwischen den mindestens zwei vorgelagerten Anschlussklemmen (18, 28) und den mindestens zwei inneren Anschlussklemmen (17, 27) verbunden ist, wobei die Stromabschaltvorrichtung (71) Kontakte aufweist, die es ermöglichen, den zwischen den mindestens zwei vorgelagerten Anschlussklemmen (18, 28) und den mindestens zwei inneren Anschlussklemmen (17, 27) fließenden Strom fließen zu lassen oder zu unterbrechen,
- wobei die mindestens zwei inneren Anschlussklemmen (17, 27) mit den mindestens zwei vorgelagerten Bereichen (11, 21) des Schutzmoduls (60) verbunden sind,
- wobei die Stromabschaltvorrichtung (71) des Fehlerstromschutzschalters (70) verbunden und eingerichtet ist, um einen von einem Betätiger (63) des Schutzmoduls (60) gesendeten Befehl zu empfangen und auszuführen.

## Claims

1. Current measurement device (1), which device is arranged so as to be incorporated within a substantially parallelepipedal housing (2) including an upstream face (3) opposite a downstream face (4), a front face (5) opposite a back face (6), and a first lateral face (7) opposite a second lateral face (8), said current measurement device (1) including:
- at least two upstream connection lands (11, 21), which lands are intended to be electrically connected to connection lands (17, 27) of an electric current breaking device (71) for protecting at least two electrical lines (19, 29);
- at least two downstream connection lands (15, 25), which lands are intended to be electrically connected to operating terminals (16, 26);
- at least two current conductors (10, 20), each current conductor being arranged so as to electrically link an upstream connection land (11, 21) to a downstream connection land (15, 25), respectively;
- at least two current sensors (51, 52), each current sensor being positioned around a respective current conductor (10, 20) so as to form a respective passage (51A, 52A) for the current conductor along an axis oriented in a first direction (X) in the upstream face (3)-downstream face (4) direction; and
- a differential current sensor (55) positioned around the set of the at least two current conductors (10, 20) so as to form a common passage (55A) for the current conductors (10, 20) along an axis oriented in a second direction (Y) in the front face (5)-back face (6) direction,
each upstream connection land (11, 21) being aligned along an axis that is oriented in the first direction (X) with each respective downstream connection land (15, 25) to which said upstream connection land (11, 21) is linked by a respective current conductor (10, 20);
said current measurement device (1) being **characterized in that** it is intended to measure the currents flowing through three phase lines and one neutral line of a three-phase electrical network, and **in that** it includes a first, a second and a third current sensor (51, 52, 53), each current sensor being intended to measure a current flowing through each of the phases, and includes a fourth current sensor (54) that is intended to measure a current in the neutral line, the fourth current sensor (54) being positioned around a neutral conductor (40) so as to form a passage for the current conductor (54A) along an axis oriented in a third direction (Z) in a first lateral face (7)-second lateral face (8) direction.

2. Current measurement device (1) according to Claim 1, **characterized in that** the current sensors (51, 52) on the one hand and the differential current sensor (55) on the other hand are respectively embedded in spaces (90, 91) that are superposed between the front face (5) and the back face (6), such that:
- the current sensors (51, 52) are positioned in a first space (90) of the housing (2), said first space (90) being delimited by the front face (5), the first lateral face (7), the second lateral face (8), the upstream face (3), the downstream face (4), and an interface plane (9) that is located between the front face (5) and the back face (6); and
- the differential current sensor (55) is positioned in a second space (91) of the housing (2), said second space (91) being delimited by the interface plane (9), the first lateral face (7), the second lateral face (8), the upstream face (3), the downstream face (4) and the back face (6).

3. Current measurement device (1) according to Claim 2, **characterized in that** the upstream connection lands (11, 21) are located level with the second space (91) of the housing.

4. Current measurement device (1) according to either of Claims 2 and 3, **characterized in that** the downstream connection lands (15, 25) are located level with the first space (90) of the housing.

5. Current measurement device (1) according to any one of Claims 1 to 4, **characterized in that** each current conductor (10, 20) is composed of three portions:
- a first conductor portion (12, 22) that is electrically connected, by a first of its ends (12A, 22A), to the upstream connection land (11, 21), said first conductor portion (12, 22) being arranged so as to pass through the common passage (55A) through the differential current sensor (55) and arranged so as to be electrically connected, by a second of its ends (12B, 22B), to a first end (13A, 23A) of a second conductor portion (13, 23);
- the second conductor portion (13, 23) of rectangular section that is electrically connected, by a first of its ends (13A, 23A), to the second end (12B, 22B) of the first conductor portion (12, 22), said first end (13A, 23A) being positioned substantially in the interface plane (9), and bent at a second of its ends to form a flat land (13B, 23B) that is oriented in a plane perpendicular to the first direction (X); and
- a third conductor portion (14, 24) that is electrically connected, by a first of its ends (14A, 24A), to the flat land (13B, 23B) formed by the second end of the second conductor portion (13, 23), said third conductor portion (14, 24) being arranged so as to pass through the passage (51A, 52A) through a current sensor (51, 52) and arranged so as to be electrically connected, by a second of its ends (14B, 24B), to the downstream connection land (15, 25).

6. Current measurement device (1) according to Claim 5, **characterized in that** each third conductor portion (14, 24) passes through the passage through the current sensor (51A, 52A) that surrounds it at least twice, forming a loop.

7. Current measurement device (1) according to Claim 5, **characterized in that** the section of the first, second and third portions of each conductor (12, 13, 14, 22, 23, 24) is substantially identical in terms of area.

8. Method for manufacturing a current measurement device (1) according to one of the preceding claims, including the following steps:
- welding (100) each first end (13A, 23A) of each second conductor portion (13, 23) to each second end (12B, 22B) of each first conductor portion (12, 22) so as to form a segment of each current conductor (123, 223, 323, 423);
- depositing (110) an insulating coating on each conductor segment (123, 223, 323, 423) so as to electrically insulate each conductor segment (123, 223, 323, 423), first and second ends (12A, 13B, 22A, 23B) of each of said conductor segments being left free of coating for the purpose of later welding;
- welding (120) each downstream connection land (15, 25, 35, 45) to each second end (14B, 24B, 34B, 44B) of each third portion (14, 24, 34, 44), respectively;
- passing (130) each third portion (14, 24, 34, 44) of each of the conductors respectively through the passage (51A, 52A, 53A and 54A) formed by the respective current sensor (51, 52, 53, 54);
- selecting (131) a single or double pass-through production variant and, in the case of a double pass-through:
- a step of bending (132) the third portions of the current conductors (14, 24, 34, 44) so as to form a loop around each respective sensor (51, 52, 53, 54); and
- passing (133) each third portion (14, 24, 34, 44) of each of the conductors through the passage (51A, 52A, 53A and 54A) a second time;
- welding (140) each first end (14A, 24A, 34A, 44A) of each third portion (14, 24, 34, 44) to each segment (123, 223, 323, 423) at the second end (13B, 23B, 33B and 43B) of the second portions (13, 23, 33 and 43), respectively;
- passing (150) the first ends (12A, 22A, 32A, 42A) of the conductor segments through the common passage (55A) formed by the differential current sensor (55);
- welding (160) each upstream connection land (11, 21, 31, 41) to each first end (12A, 22A, 32A, 42A) of each conductor segment (123, 223, 323, 423), respectively; and
- positioning (170) a brace (80) for holding the first ends (12A, 22A, 32A, 42A) of the first portions in a predefined position.

9. Module (60) for protection from electrical faults that is intended to cooperate with an electric current breaking device (71), said protection module including:
- a processing unit (61);
- an actuator (63) for actuating the electric current breaking device (71); and
- an adjustment device (62) that is linked to the processing unit (61), said adjustment device (62) being arranged so as to adjust at least a first trip threshold (SD) and/or a second trip threshold (SDD),
said module for protection from electrical faults being **characterized in that** it includes a current measurement device (1) according to any one of Claims 1 to 7, said measurement device including:
- at least two current sensors (51, 52);
- a differential current sensor (55); and
- at least two current conductors (10, 20) that are electrically linked to upstream lands (11, 21) and downstream lands (15, 25),
the processing unit (61) being connected to the current sensors (51, 52) and to the differential current sensor (55) so as to form:
- at least one measurement (M) of the current flowing through each of the current conductors (51, 52); and
- a measurement of the differential current (MD) across all of the current conductors (51, 52), the processing unit (61) being arranged so as to activate the actuator (63) to actuate the electric current breaking device (71) when the current measurement (M) is higher than the first trip threshold (SD) or when the measurement of the differential current (MD) is higher than the second trip threshold (SDD).

10. Differential circuit breaker (70) intended to protect an electrical circuit including at least two electrical lines (19, 29) from electrical faults, said circuit breaker including:
- at least two upstream connection terminals (18, 28) for connecting at least the two electrical lines (19, 29);
- at least two internal connection terminals (17, 27); and
- an electric current breaking device (71),
**characterized in that** said circuit breaker further includes a module (60) for protection from electrical faults according to Claim 9,
- the electric current breaking device (71) being connected between the at least two upstream connection terminals (18, 28) and the at least two internal connection terminals (17, 27), said electric current breaking device (71) including contacts allowing the current flowing between the at least two upstream connection terminals (18, 28) and the at least two internal connection terminals (17, 27) to be established or interrupted;
- the at least two internal connection terminals (17, 27) being connected to the at least two upstream lands (11, 21) of the protection module (60);
- the electric current breaking device (71) of the differential circuit breaker (70) being connected and arranged so as to receive and to execute a command transmitted by an actuator (63) of the protection module (60).
